(19) Europäisches Patentamt
European Patent Office
Office européen des brevets

(11) Publication number: 0 040 377
B1

(12) EUROPEAN PATENT SPECIFICATION

(45) Date of publication of patent specification: 03.09.86

(51) Int. Cl.$^4$: H 01 L 27/08, G 11 C 11/34

(21) Application number: 81103540.1

(22) Date of filing: 08.05.81

# (54) Integrated circuit device for writing and reading information.

(30) Priority: 19.05.80 JP 66245/80

(43) Date of publication of application: 25.11.81 Bulletin 81/47

(45) Publication of the grant of the patent: 03.09.86 Bulletin 86/36

(84) Designated Contracting States: DE FR GB

(56) References cited:
US-A-3 971 001

INTERNATIONAL ELECTRON DEVICES MEETING, TECHNICAL DIGEST, 5th-7th December 1977, pages 291-293, Washington D.C., USA, S. FUKUNAGA et al.: "FA-CMOS process for low power PROM with low avalanche injection voltage"

RCA TECHNICAL NOTES, no. 876, 12th February 1971, pages 1-4, Princeton, N.J., USA, W.J. DENNEHY: "Non-latching integrated circuits"

(73) Proprietor: Kabushiki Kaisha Toshiba
72, Horikawa-cho Saiwai-ku
Kawasaki-shi Kanagawa-ken 210 (JP)

(72) Inventor: Wada, Masashi
2-8-2, Shiomidai
Isogo-ku Yokohama-shi (JP)

(74) Representative: Blumbach Weser Bergen Kramer Zwirner Hoffmann Patentanwälte
Radeckestrasse 43
D-8000 München 60 (DE)

(56) References cited:
PATENTS ABSTRACTS OF JAPAN, vol. 4, no. 44(E-5)(526), 5th April 1980, page 78E5

EP 0 040 377 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

This invention relates to an integrated circuit device for writing and reading information which includes non-volatile memory elements and complementary insulated-gate type field effect transistors.

Insulated-gate type field effect transistors which have a SAMOS structure or a MNOS structure are well-known as non-volatile memory elements. A large number of memory elements of these kinds are integrated on a semiconductor substrate ordinarily like a matrix. A "1" or "0" is selectively written into each of the memory elements and is read out from the same by a control circuit formed therearound. Such an integrated circuit device is desired to have less power consumption in order to suppress heat production.

An integrated circuit device with a control circuit of complementary insulated-gate type field effect transistors (CMOS devices) for controlling non-volatile memory arrays, which may satisfy the above requirement, is disclosed in IEEE JOURNAL OF SOLID-STATE CIRCUITS, VOL. SC-13, No. 5, OCTOBER 1978, PP. 677—680. Technical Digest 1977 International Electron Devices Meeting, December 5, 6 and 7, Washington, pages 291—293 and JP—A—55 15 222.

As shown in the above literature, it is conventional that complementary insulated-gate type field effect transistors (a CMOS device) comprise a N-type semiconductor substrate, a P-type well region formed in the substrate, a N-channel MOS transistor formed on the well region and a P-channel MOS transistor formed on the substrate; wherein the gate electrodes of the N-channel and P-channel transistors are commonly connected, thereby constituting an input terminal and the drain regions of both transistors are commonly connected, thereby constituting an output terminal. While a predetermined voltage is applied between the two source regions of both transistors, the CMOS device operates as an inverter. The above mentioned CMOS device has essentially a PNPN structure comprising the source of the P-channel MOS transistor, the N-type semiconductor substrate, the P-type well region and the source of the N-channel MOS transistor. It is possible that the PNPN structure works as a thyristor and then a circuit between the sources of the two transistors is short-circuited due to a noise signal being introduced into the PNPN structure, so that the control circuit of the CMOS devices may cause an error behaviour or may be broken in the worst case. Such a phenomenon that a parastic thyristor is wrongly turned on is called "Latch-up". This Latch-up phenomenon can be essentially caused also in the case that both non-volatile memory elements and CMOS devices are formed together on a same semiconductor substrate.

A consideration for preventing the Latch-up phenomenon of CMOS devices is disclosed in DENSHI TSUSHIN GAKKAI RONBUNSHI Vol. J61-C, No. 2, 1978, PP. 106—113. In this literature, the following concrete means are shown as countermeasures for the Latch-up phenomenon. One of the means is to isolate electrically the P-channel MOS transistors and the N-channel MOS transistors by forming insulator layers therebetween. Another of the means is to cut off electric channels between the P-channel MOS transistors and the P-type well regions by forming P-type regions of a low impurity concentration therebetween.

Yet another of the means is to determine the mutual positional relation between the P-channel transistors and the N-channel transistors in order to prevent thyristor action of the CMOS devices, JP—A—55 15 222. Yet another of the means is to determine the electric characteristics of the N-channel and P-channel transistors so as to prevent thyristor action of the CMOS devices. However these countermeasures bring inevitably lower integration density, more complicated manufacturing processes or worse performance of the CMOS devices as inverters.

The document RCA Technical Notes, No. 876, 12 February 1971, pages 1—4 discloses a possibility of preventing the latch-up phenomenon in a CMOS circuit. In this case the P-well normally used in CMOS structures is surrounded by an $N^+$ guard ring diffused into an epitaxial silicon film all the way through to an $N^+$ substrate. All possible PNPN paths in this structure must pass through the $N^+$ guard ring. The life-time in this region is very low and consequently a latch-up phenomenon caused by parasitic thyristors is said not to occur.

The document Technical 1977 International Electron Devices Meeting, already mentioned before shows an $N^+$ isolation formed in a surface region of a $N^-$ substrate between a FAMOS element and a CMOS circuit.

It is an object of the present invention to provide an integrated circuit device for writing and reading information including a non-volatile memory element and a CMOS circuit on the same substrate and which does not suffer from the latch-up phenomenon.

This object is achieved with an integrated circuit device as claimed in claim 1.

This integrated circuit device has a high integration density and a superior inverter performance of complementary insulated-gate type field effect transistors and can be fabricated with ease.

Specific embodiments of the invention are claimed in the dependent claims.

It is essential that a predetermined voltage, for example a ground voltage or a negative voltage, should be directly applied to the second semiconductor region, in order to have the region effect as, a drain of the substrate current. To that end the second semiconductor region is connected to the voltage source terminal. Furthermore, the impurity concentration of the second semiconductor region is desired to be from $1 \times 10^{20}$ $cm^{-3}$ to $1 \times 10^{22}$ $cm^{-3}$ so as to have a good contact with an electrode, to which the predetermined voltage is applied. In connection with these points, the second semiconductor region can be obviously distinguished from a semiconductor region of one conductivity type which is formed conventionally in a semiconductor substrate of one conductivity type, for the purpose of preventing leakage of current from MOS transistors which may be caused by what is called the inversion phenomenon. Namely the conventional semiconductor region, to which any voltage is never directly applied, has ordinarily an impurity concentration order of $10^{17}$ $cm^{-3}$.

The invention will be described in detail with reference to the accompanying drawings.

Brief Description of the Drawings

FIG. 1 shows a schematic view of one embodiment of the integrated circuit device according to the invention;

FIG. 2 shows a circuit diagram of a memory array in the device of Fig. 1;

FIG. 3 shows a magnified cross-sectional view taken along line A—A in Fig. 1;

FIG. 4 shows a substrate current absorption characteristic of the device shown in FIG. 1 to 3;

FIG. 5 is a curve which shows a relation between a substrate current $I_{SUB}$ and a source current $I_{DD}$ in a parastic thyristor according to a conventional integrated circuit device.

Detailed Description of Preferred Embodiments

The cause of the Latch-up phenomenon in integrated circuit devices which respectively comprise plural non-volatile memory elements and plural sets of two complementary insulated-gate type field effect transistors (CMOS devices) formed together on same semiconductor substrates has been studied. Practically information is stored into an insulated-gate type field effect transistor (a non-volatile memory element) with a SAMOS structure or a MNOS structure according to the following operation. At first, electrons or holes are produced through collision of accelerated carriers with atoms. The electrons or holes are injected into traps existing between a semiconductor substrate and a control electrode of the transistor. Then the traps store the information.

At the same time, a substrate current which has been produced near by the non-volatile memory elements flows into the CMOS devices. Then the parastic thyristors of the CMOS devices are turned on, so that the CMOS devices may operate in an error manner or may be broken themselves by an overcurrent.

According to the invention, the substrate current is absorbed through applying a predetermined voltage directly to at least one semiconductor region of one conductivity type, which has an impurity concentration higher than that of the semiconductor substrate and which is formed between the non-volatile memory elements and the CMOS devices. The Latch-up phenomenon of the CMOS devices is decreased very much without changing the CMOS structures themselves.

One embodiment of the invention will be described in detail with reference to Fig. 1 to 3.

In Fig. 1, memory arrays 2, 3 are formed on a semiconductor substrate 1 of P conductivity type of a $2 \times 10^{14}$ $cm^{-3}$ impurity concentration. The memory arrays 2, 3 are constituted by insulated-gate field effect transistors of a SAMOS structure. Each memory array 2, 3 consists of four memory blocks and in each of the memory blocks, there is formed like a matrix a circuit of insulated-gate field effect transistors (MOS transistors) 4A to 4Z with a SAMOS structure as shown in Fig. 2. Circuits 5 to 12 which include plural sets of two complementary insulated-gate field effect transistors (CMOS devices) are formed around the memory arrays 2, 3 in order to control writing information into the transistors 4A to 4Z and reading out the information therefrom.

Furthermore, bonding pads 13 to 36 are formed on insulator films which cover the substrate 1 around the circuit 5 to 12. The bonding pads are utilized as power source terminals, input terminals and output terminals respectively. Each of the CMOS devices which constitute the circuits 5 to 12 consists of a P-channel type MOS transistor and a N-channel type MOS transistor. A predetermined voltage is applied between the sources of the two transistors. The gates of the two transistors are connected commonly, thereby forming an input terminal. The drains of the two transistors are connected commonly, thereby forming an output terminal.

These CMOS devices work as inverters. Row address signals are sent into a row address buffer circuit 12 through the pads 13 to 16 and the pads 33 to 35. In the circuit 12, the row address signals are converted into driving signals for a row decoder and row selecting circuit 5.

On the other hand, column address signals are sent into a column address buffer circuit 6 through the pads 17 to 20. In the circuit 6, the column address signals are converted into driving signals for a column decoder circuit 9. Data signals are provided to a data input and output buffer circuit 10 through the pads 21 to 23 and the pads 25 to 29. This circuit 10 selects each of 8 blocks in the memory arrays 2, 3 one after another. In a selected block, one of the non-volatile memory transistors is designated by the row decoder and row selecting circuit 5 and the column selecting circuit 7, 8 which are controlled by the signals from the column decoder circuit 9. Then a "1" or "0" is written into the designated non-volatile memory transistor (or therefrom a "1" or "0" is read out). Control of writing and reading is carried out by a control circuit 11 which receives control signals from the pads 30 to 32. A power source voltage is applied to the pad 36. A ground voltage is applied to the pad 24. Long and narrow regions 40, 41 are formed in a surface region of the semiconductor substrate 1 around said memory arrays 2, 3. The regions 40, 41 to which a ground voltage is applied through the pad 24, have P-conductivity type and a 4 × $10^{21}$ $cm^{-3}$ impurity concentration.

Fig. 3 is a magnified cross-sectional view taken along line A—A in Fig. 1.

In Fig. 3, a well region 43 of N-conductivity type having a 6 × $10^{15}$ $cm^{-3}$ impurity concentration is formed in the P-type semiconductor substrate 1. In the N-type well region 43, there is formed a N-type region 44 of a 4 ×$10^{21}$ $cm^{-3}$ impurity concentration, a P-type source region 46 and a P-type drain region 47 respectively having a 4 × $10^{21}$ $cm^{-3}$ impurity concentration and these regions constituting a P-channel type MOS transistor 45. An insulator film 48 of silicon dioxide is formed between the source region 46 and the drain region 47 on the N-type region 43. Further, a poly-silicon gate electrode 49 is formed on the insulator film 48. A N-type source region 51 and an N-type drain region 52 respectively having a 4 × $10^{21}$ $cm^{-3}$ impurity concentration and constituting a N-channel type MOS transistor 50, are formed in the P-type surface region of the substrate 1. An insulator film 53 of silicon dioxide is formed between the source region 51 and the drain region 52 on the substrate 1. A poly-silicon gate electrode 54 is formed on the insulator film 53. A P-type region 56 of a 4 × $10^{21}$ $cm^{-3}$ impurity concentration is formed adjoining the source region 51 in the N-type surface region of the substrate 1. It is not always necessary that the region 56 is brought into contact with the source region 51. The P-type region 56 and the N-type source region 51 are connected commonly to an aluminium electrode 57, to which a ground voltage Vss is applied. The substrate 1 is grounded through the electrode 57. The N-type region 44 in the N-type well region 43 and the P-type source region 46 of the transistor 45 are connected commonly to an aluminium electrode 58, to which a voltage of +5 V is applied. The N-type well region 43 is kept at a positive potential through the N-type region 44 and the electrode 58. Accordingly, the P-N junction between the N-type well region 43 and the P-type substrate 1 is backward-biased and the region 43 and the substrate 1 are electrically isolated from each other.

The gate electrodes 49, 54 of the transistors 45, 50 are connected commonly to an aluminium electrode 60 and the drain regions 47, 52 of the transistors 45, 50 are connected commonly to an aluminium electrode 61.

An input signal Vi for a CMOS device 62 which consists of the two transistors 45, 50 is supplied to the electrode 60, and the CMOS device 62 operates as an inverter. An output signal Vo is obtained from the electrode 61.

A N-type source region 66 and a N-type drain region 67 respectively of a 4 × $10^{21}$ $cm^{-3}$ impurity concentration, which constitute an insulated-gate field effect non-volatile memory transistor 65 of a SAMOS structure, are formed spaced-apart from the CMOS device 62 on the substrate 1. An insulator film 68 of silicon dioxide is formed between the source region 66 and the drain region 67 on the substrate 1. A floating-gate electrode 69 of poly-silicon is disposed on the insulator film 68. Furthermore, there is formed an insulator film 70 of silicon dioxide on the floating-gate electrode 69. A control-gate electrode 71 is formed on the insulator film 70. The control-gate electrode 71 is connected to an aluminium electrode 72, to which a gate-control voltage $V_G$ is applied. The source region 66 is connected to an aluminium electrode 73, to which a ground voltage Vss is applied. The drain region 67 is connected to an aluminium electrode 74, to which a drain-control voltage $V_D$ is applied. When +16 Volt is applied to the drain electrode 74 and +20 Volt is applied to the control-gate electrode 71, then electrons which have been flowing through a channel are discharged into a depletion layer at a pinch-off point near by the junction between the drain region 67 and the substrate 1. These electrons are accelerated by the electric field which exists in the depletion layer and come into collision with atoms constituting the substrate 1. Through the collision, the atoms are ionized and simultaneously hot electrons and holes are produced. This phenomenon is called "Impact-ionization".

These hot electrons are injected into the floating-gate electrode 69 and/or the boundary face between the electrode 69 and the insulator film 68 by the electric field between the control-gate electrode 71 and the substrate 1, and then the hot electrons are trapped. Through the above process, the writing operation is performed and a substrate current is formed by the holes which have been produced simultaneously. If a voltage higher that the above voltage (+20 ~ +21 Volt) is applied to the drain electrode 74, an avalanche break-down occurs at the P-N junction between the drain region 67 and the substrate 1, so that hot electrons and holes are produced. Then, these hot electrons are directly injected into the floating-gate electrode 69 and/or the boundary face between the electrode 69 and the insulator film 68.

In order to read out the information from the non-volatile memory transistor 65, there should be applied +2 Volt to the drain electrode 74 and +5 Volt to the control-gate electrode 72.

Furthermore, in order to erase the information stored in the non-volatile memory transistor 65, ultraviolet rays should be applied to the gate region of the transistor 65 or −50 to −60 Volt should be applied to the control-gate electrode 72.

The above-mentioned P-type region 40, by which the invention is characterized, is formed in a surface region of the substrate 1 between the non-volatile memory transistor 65 and the CMOS device 62. The P-type region 40 has an impurity concentration of 4 × $10^{21}$ $cm^{-3}$ and is connected to an aluminium electrode 80, to which a ground voltage is applied. The surface of the substrate 1 is covered with an insulator film 81 of silicon dioxide. In the insulator film 81, contact holes for the electrodes are selectively formed. An integrated circuit device of the above structure can be fabricated through conventional methods. In the above mentioned device, holes flow in the substrate 1 on the writing operation, and then a substrate current $I_{SUB}$ is formed. Most of the substrate current is absorbed into the electrode 80 connected to the P-type region 40. The rest of the substrate current is injected into the P-type region 56 disposed close to the transistor 50. This tendency is shown in Fig. 4. In Fig. 4 CURVE 90 shows current absorption values of the electrode 80 and CURVE 91 shows current absorption values of the electrode 57. From these curves it is understood that error behavior and breakdown of the CMOS device 62 are effectively prevented according to the above mentioned structure.

In this respect, if the P-type region 40 does not exist in the substrate 1, most of the substrate current $I_{SUB}$ produced through the writing operation of the non-volatile memory transistor 65 will be injected into the P-type region 56. As a result, an electric potential of a substrate region near by the region 56 will rise due to the substrate current which flows through a resistance of the substrate 1. Then a P-N junction between the N-type source region 51 of the transistor 50 and the substrate 1 will be forward-biased, so that electrons will be injected from the source region 51 through the substrate 1 and the N-type well region 43 into the N-type region 44. Also a P-N junction between the N-type well region 43 and the source region 46 will be forward-biased so that holes will be injected from the source region 46 through the N-type well region 43 and the P-type substrate 1 into the N-type source region 51. In this way, a great value current will begin to flow between the electrodes 58, 57 on account of positive feedback effect of the parasitic thyristor, which has a PNPN structure comprising the P-type source region 46 of the transistor 45, the N-type well region 43, the P-type substrate 1 and the N-type source region 51 of the transistor 50. Once the parasitic thyristor is turned on and a great value current begins to flow, the current will continue to flow unchanged even if the cause, that is to say the substrate current, is removed.

This Latch-up phenomenon is caused only under the condition that a substrate current flows in the substrate and independently of whether or not the P-type region 56 exists around the CMOS device 62.

Fig. 5 shows a relation between substrate current values $I_{SUB}$ and current values $I_{DD}$ of the current which flows into the source electrode 58 in accordance with a conventional device, wherein the P-type region 40 does not exist in the substrate 1. From the curve in Fig. 5 it is well understood that when the substrate current $I_{SUB}$ comes to have a great value more than 1.12 mA, the parastic thyristor is turned on and the current $I_{DD}$ increases abruptly.

In the above mentioned embodiment, it is possible that a negative voltage is adopted as a voltage to be applied to the P-type region 40. In this case, a substrate current can be even more effectively absorbed, compared with the case that a ground voltage is applied to the P-type region 40. In the above mentioned embodiment the P-type region of a high impurity concentration for substrate current absorption is allowed to have a shape similar to a loop with a crack as shown with a reference mark "41" in Fig. 1.

**Claims**

1. An integrated circuit device for writing and reading information comprising:

a semiconductor substrate (1) of one conductivity type having at least one first semiconductor region (43) of the opposite conductivity type;

plural sets (5—12) of two complementary insulated-gate type field effect transistors (62) which constitute a control circuit for writing and reading information, one (45) of the two transistors (62) of each of the sets (5—12) being of said one conductivity channel type including a first source region (46) and a first drain region (47) of said one conductivity type spaced-apart from each other in the first semiconductor region (43), a first insulator layer (48) on the first semiconductor region (43) between the first source region (46) and the first drain region (47), and a first gate electrode (49) on said first insulating layer (48), the other (50) of the two transistors of each set being of said opposite conductivity channel type including a second source region (51) and a second drain region (52) of said opposite conductivity type spaced-apart from each other in the semiconductor substrate (1), a second insulator layer (53) on said substrate (1) between the second source region (51) and the second drain region (52), and a second gate electrode on the second insulator layer (53), wherein the first source region (46) is connected to a first voltage ($V_{DD}$) source terminal, the second source region (51) is connected to a second voltage (Vss) source terminal, the first and second gate electrodes (49, 54) are commonly connected to an input terminal, and the first and second drain regions (47, 52) are commonly connected to an output terminal;

a plurality of non-volatile memory elements (65) for storing the information, which are formed and arranged like a matrix on the semiconductor substrate (1) spaced-apart from the plural sets (5—12, 62) of two transistors, the non-volatile memory elements being insulated-gate type elements each including a third source region (66) and a third drain region (67) of said opposite conductivity type spaced apart from each other in the semiconductor substrate (1), a third insulator layer (68) on the substrate (1) between the third source region (66) and the third drain region (67), and a floating gate electrode (69) on the third insulator layer (68), wherein the third source region (66) is connected to a third voltage (Vss) source terminal, and the third drain region (67) is connected to a drain-control voltage ($V_D$) terminal; and

a second semiconductor region (40, 41) of said one conductivity type, having an impurity concentration higher than that of the semiconductor substrate (1), which is formed between the plural sets (5—12, 62) of two transistors and the plural non-volatile memory elements (2—3, 65) in a surface region of the semiconductor substrate (1);

characterized in that the second semiconductor region (40, 41) surrounds the matrix-arranged plurality of non-volatile memory elements (65) and is connected to a predetermined voltage (Vss) source terminal.

2. The integrated circuit device according to claim 1, wherein each of the non-volatile memory elements (65) further comprises a fourth insulator layer (70) formed on the floating gate electrode (69) and a control-gate electrode (71) formed on the fourth insulator layer, the control-gate electrode (71) being connected to a gate-control voltage ($V_G$) terminal.

3. The integrated circuit device according to claim 1, wherein said semiconductor substrate has P conductivity type and the predetermined voltage (Vss) source terminal is a ground or negative voltage source terminal.

4. The integrated circuit device according to claim 1, wherein the device further comprises a third semiconductor region (56) of said one conductivity type and of a higher impurity concentration than that of said semiconductor substrate (1), the third semiconductor region (56) being formed near at least one (50) of the field effect transistors (62) of said opposite conductivity channel type and spaced-apart from the second semiconductor region (40, 41), and being connected to said predetermined voltage (Vss) source terminal.

5. The integrated circuit device according to claim 1, wherein the second and third voltage source terminals and the predetermined voltage source terminal are common.

**Patentansprüche**

1. Integrierte Schaltung zum Schreiben und Lesen von Informationen umfassend:

ein Halbleitersubstrat (1) eines Leitungstyps mit wenigstens einer ersten Halbleiterzone (43) des entgegengesetzten Leitungstyps,

mehrere Sätze (5—12) von zwei komplementären Feldeffekttransistoren (62) mit isoliertem Gate, die eine Steuerschaltung zum Schreiben und Lesen von Informationen bilden, wobei einer (45) der beiden Transistoren (62) jedes Satzes (5—12) von der Art mit einem Kanal des einen Leitungstyps ist und eine erste Sourcezone (46) sowie eine erste Drainzone (47) des einen Leitungstyps aufweist, die voneinander getrennt in der ersten Halbleiterzone (43) ausgebildet sind, eine erste Isolierschicht (48) auf der ersten Halbleiterzone (43) zwischen der ersten Sourcezone (46) und der ersten Drainzone (47) und eine erste Gateelektrode (49) auf der ersten Isolierschicht (48), wobei der andere (50) der beiden Transistoren jedes Satzes von der Art mit einem Kanal des entgegengesetzten Leitungstyps ist und eine zweite Sourcezone (51) sowie eine zweite Drainzone (52) des entgegengesetzten Leitungstyps aufweist, die voneinander getrennt in dem Halbleitersubstrat (1) angeordnet sind, eine zweite Isolierschicht (53) auf dem Substrat (1) zwischen der zweiten Sourcezone (51) und der zweiten Drainzone (52) und eine zweite Gateelektrode auf der zweiten Isolierschicht (53), wobei die erste Sourcezone (46) mit einem ersten Spannungsquellenanschluß ($V_{DD}$) verbunden ist, die zweite Sourcezone (51) mit einem zweiten Spannungsquellenanschluß (Vss) verbunden ist, die erste und die zweite Gateelektrode (49, 54) gemeinsam mit einem Eingangsanschluß verbunden sind und die erste und die zweite Drainzone (47, 52) gemeinsam mit einem Ausgangsanschluß verbunden sind,

eine Vielzahl von nicht-flüchtigen Speicherelementen (65) zur Speicherung der Informationen, die in Form einer Matrix auf dem Halbleitersubstrat (1) angeordnet und von den mehreren Sätzen (5—12, 62) von zwei Transistoren beabstandet sind, wobei die nicht-flüchtigen Speicherelemente Elemente des Typs mit isoliertem Gate sind, von denen jedes eine dritte Sourcezone (66) und eine dritte Drainzone (67) des entgegengesetzten Leitungstyps einschließt, die voneinander beabstandet im Halbleitersubstrat (1) ausgebildet sind, eine dritte Isolierschicht (68) auf dem Substrat (1) zwischen der dritten Sourcezone (66) und der dritten Drainzone (67), und eine schwimmende Gateelektrode (69) auf der dritten Isolierschicht (68), wobei die dritte Sourcezone (66) mit einem dritten Spannungsquellenanschluß (Vss) verbunden ist und die dritte Drainzone (67) mit einem Drainsteuerspannungsanschluß ($V_D$) verbunden ist, und

eine zweite Halbleiterzone (40, 41) des einen Leitungstyps, die eine Störstellenkonzentration aufweist, die höher ist als die des Halbleitersubstrats (1), und die zwischen den mehreren Sätzen (5—12, 62) von zwei Transistoren und den mehreren nicht-flüchtigen Speicherelementen (2—3, 65) in einer Oberflächenzone des Halbleitersubstrats (1) ausgebildet ist,

dadurch gekennzeichnet, daß die zweite Halbleiterzone (40, 41) die in einer Matrix angeordnete Vielzahl von nicht-flüchtigen Speicherelementen (65) umgibt und mit einem vorbestimmten Spannungsquellenanschluß (Vss) verbunden ist.

2. Integrierte Schaltung nach Anspruch 1, bei der jedes der nicht-flüchtigen Speicherelemente (65) ferner eine vierte Isolierschicht (70) aufweist, die auf der schwimmenden Gateelektrode (69) ausgebildet ist, und eine Steuergateelektrode (71), die auf der vierten Isolierschicht ausgebildet ist, wobei die Steuergateelektrode (71) mit einem Gatesteuerspannungsanschluß ($V_G$) verbunden ist.

3. Integrierte Schaltung nach Anspruch 1, dadurch gekennzeichnet, daß das Halbleitersubstrat einen P-Leitungstyp besitzt und der vorbestimmte Spannungsquellenanschluß (Vss) Masse oder ein negativer Spannungsquellenanschluß ist.

4. Integrierte Schaltung nach Anspruch 1, die ferner eine dritte Halbleiterzone (56) des einen Leitungstyps und eine Störstellenkonzentration besitzt, die höher ist als die des Halbleitersubstrats (1), wobei die dritte Halbleiterzone (56) nahe wenigstens eines (50) der Feldeffekttransistoren (52) der Art mit einem Kanal der entgegengesetzten Leitungstyps ausgebildet und von der zweiten Halbleiterzone (40, 41) beabstandet sowie mit dem vorbestimmten Spannungsquellenanschluß (Vss) verbunden ist.

5. Integrierte Schaltung nach Anspruch 1, bei der der zweite und der dritte Spannungsquellenanschluß und der vorbestimmte Spannungsquellenanschluß ein gemeinsamer Anschluß sind.

**Revendications**

1. Dispositif à circuit intégré pour l'écriture et la lecture d'informations, comprenant:

un substrat semiconducteur (1) d'un type de conductivité comportant au moins une première région semiconductrice (43) du type opposé de conductivité;

plusieurs groupes (5—12) de deux transistors à effet de champ du type à porte isolée complémentaires (62) qui constituent un circuit de commande pour l'écriture et la lecture d'informations, un (45) des deux transistors (62) de chacun des groupes (5—12) étant dudit type de canal de conductivité incluant une première région de source (46) et une première région de drain (47) dudit type de conductivité espacées l'une de l'autre dans la première région semiconductrice (43), une première couche isolante (48) sur la première région semiconductrice (43) entre la première région de souce (46) et la première région de drain (47), et une première électrode de grille (49) sur la première couche isolante (48), l'autre (50) des deux transistors de chaque groupe étant dudit type opposé de canal de conductivité incluant une deuxième région de source (51) et une deuxième région de drain (52) dudit type opposé de conductivité espacées l'une de l'autre dans le substrat semiconducteur (1), une deuxième couche isolante (53) sur le substrat (1) entre la deuxième région de source (51) et la deuxième région de drain (52), et une deuxième électrode de grille sur la deuxième couche isolante (53), dans lequel la première région de source (46) est connectée à une première borne de source de tension ($V_{DD}$), la deuxième région de source (51) est connectée à une deuxième borne de source de tension (Vss), la première et la deuxième électrode de grille (49, 54) sont connectées en commun à une borne d'entrée, et la première et la deuxième régions de drain (47, 52) sont connectées en commun à une borne de sortie;

un ensemble d'éléments de mémoire rémanente (65) pour mémoriser les informations, qui sont formés et disposés comme une matrice sur le substrat semiconducteur (1) en étant espacés des groupes (5—12, 62) de deux transistors, les éléments de mémoire rémanente étant des éléments du type à porte isolée incluant chacun une troisième région de source (66) et une troisième région de drain (67) du type opposé de conductivité espacées l'une de l'autre dans le substrat semiconducteur (1), une troisième couche isolante (68) sur le substrat (1) entre la troisième région de source (66) et la troisième région de drain (67), et une électrode de grille flottante (69) sur la troisième couche isolante (68), dans lequel la troisième région de source (66) est connectée à une troisième borne de source de tension (Vss), et la troisième région de drain (67) est connectée à une borne de tension ($V_D$) de contrôle de drain; et une deuxième région semiconductrice (40, 41) dudit type de conductivité, ayant une concentration en impuretés supérieure à celle du substrat semiconducteur (1), qui est formée entre l'ensemble des groupes (5—12, 62) de deux transistors et l'ensemble des éléments de mémoire rémanente (2—3, 65) dans une région de surface du substrat semiconducteur (1);

caractérisé en ce que la deuxième région semiconductrice (40, 41) entoure l'ensemble des éléments de mémoire rémanente (65) disposés en matrice et est connectée à une borne de source de tension (Vss) prédéterminée.

2. Dispositif à circuit intégré selon la revendication 1, dans lequel chacun des éléments de mémoire rémanente (65) comprend en outre une quatrième couche isolante (70) formée sur l'électrode de grille flottante (69) et une électrode de grille de contrôle (71) formée sur la quatrième couche isolante, l'électrode de grille de contrôle (71) étant connectée à une borne de tension de contrôle de grille ($V_G$).

3. Dispositif à circuit intégré selon la revendication 1, dans lequel le substrat semiconducteur a un type de conductivité P et la borne de source de tension (Vss) prédéterminée est une borne de source de tension de masse ou négative.

4. Dispositif à circuit intégré selon la revendication 1, dans lequel le dispositif comprend en outre une troisième région semiconductrice (56) dudit type de conductivité et de concentration en impuretés supérieure à celle du substrat semiconducteur (1), la troisième région semiconductrice (56) étant formée près d'au moins un (50) des transistors à effet de champ (62) dudit type opposé de canal de conductivité et espacée de la deuxième région semiconductrice (40, 41), et étant connectée à la borne de source de tension (Vss) prédéterminée.

5. Dispositif à circuit intégré selon la revendication 1, dans lequel les deuxième et troisième bornes de source de tension et la borne de source de tension prédéterminée sont communes.

FIG. 1

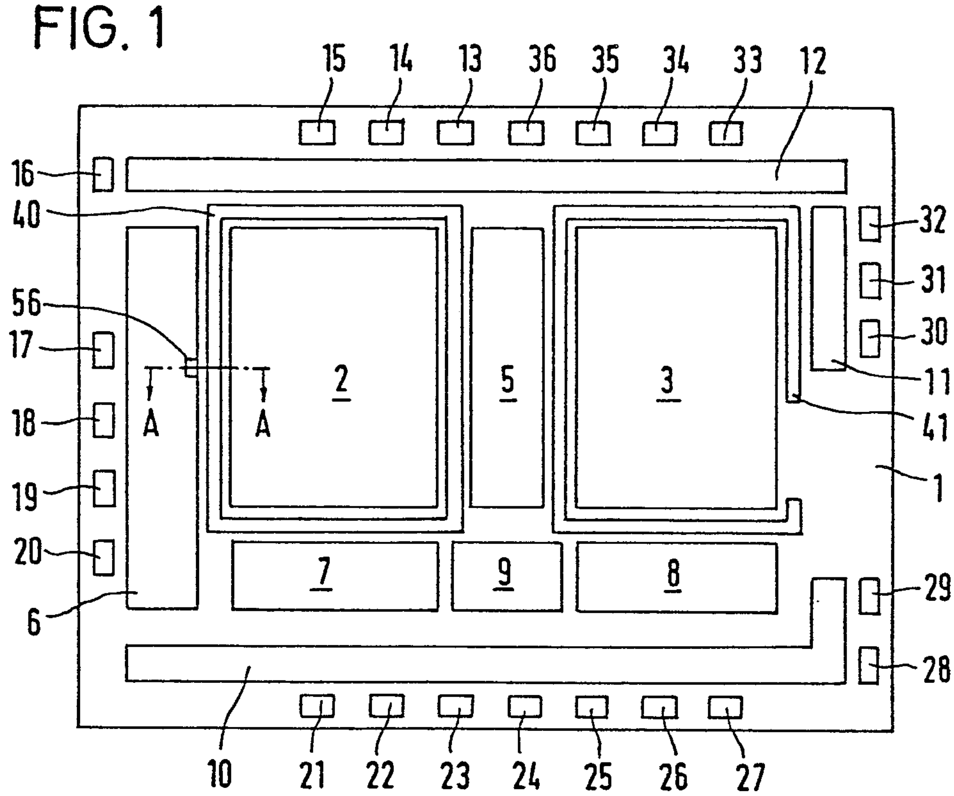
15
14
13
36
35
34
33
12
16
40
56
17
18
19
20
6
A
A
2
5
3
32
31
30
11
41
1
7
9
8
29
28
10
21
22
23
24
25
26
27

FIG. 3

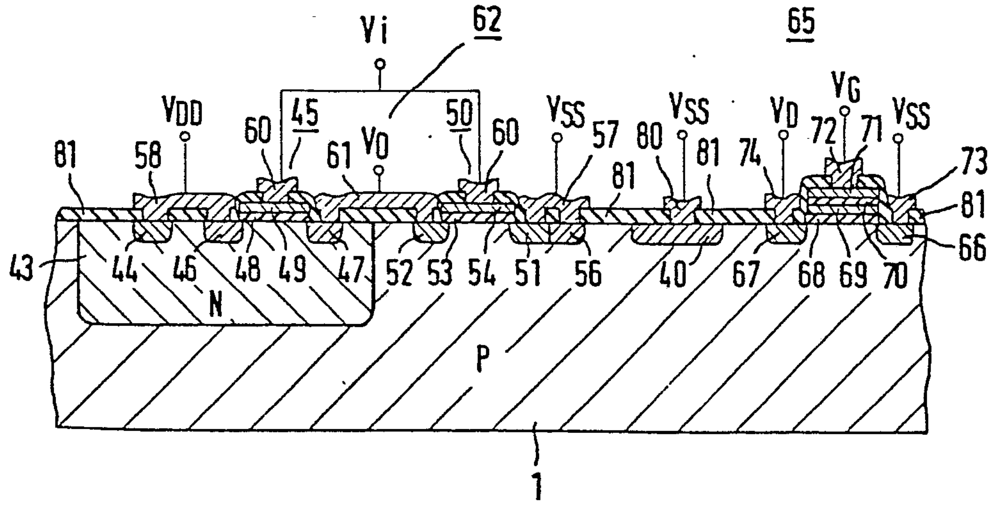
Vi
62
65
45
50
VDD
V0
VSS
VSS
VD
VG
VSS
81
58
60
61
60
57
80
81
74
72
71
73
81
43
44
46
48
49
47
52
53
54
51
56
40
67
68
69
70
66
N
P
1

FIG. 2

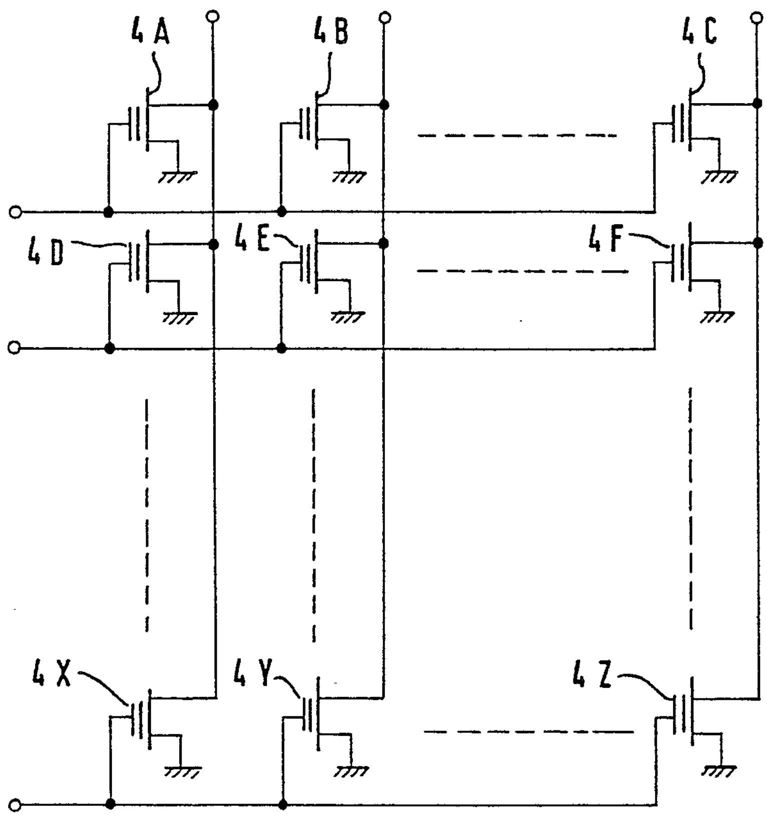

FIG. 4

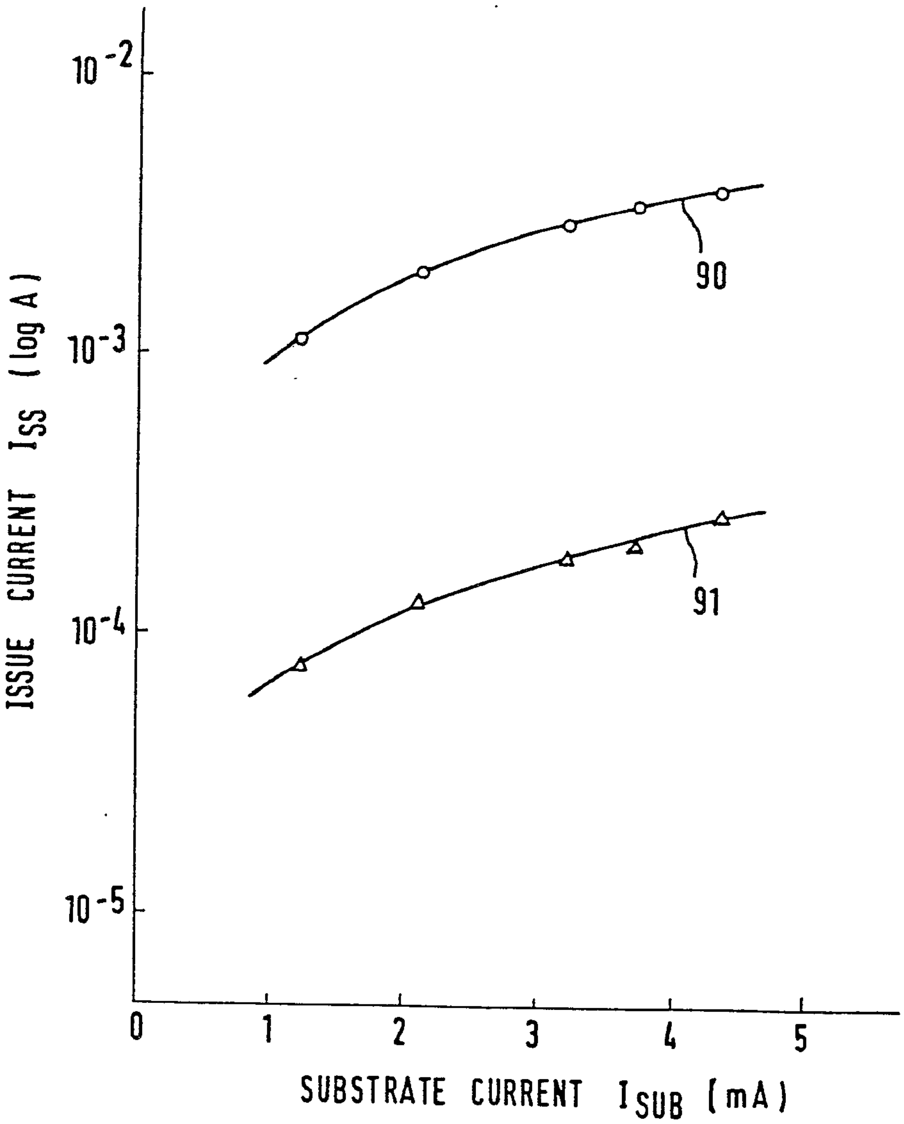

$10^{-2}$
$10^{-3}$
$10^{-4}$
$10^{-5}$
ISSUE CURRENT $I_{SS}$ (log A)
90
91
0
1
2
3
4
5
SUBSTRATE CURRENT $I_{SUB}$ (mA)

FIG. 5

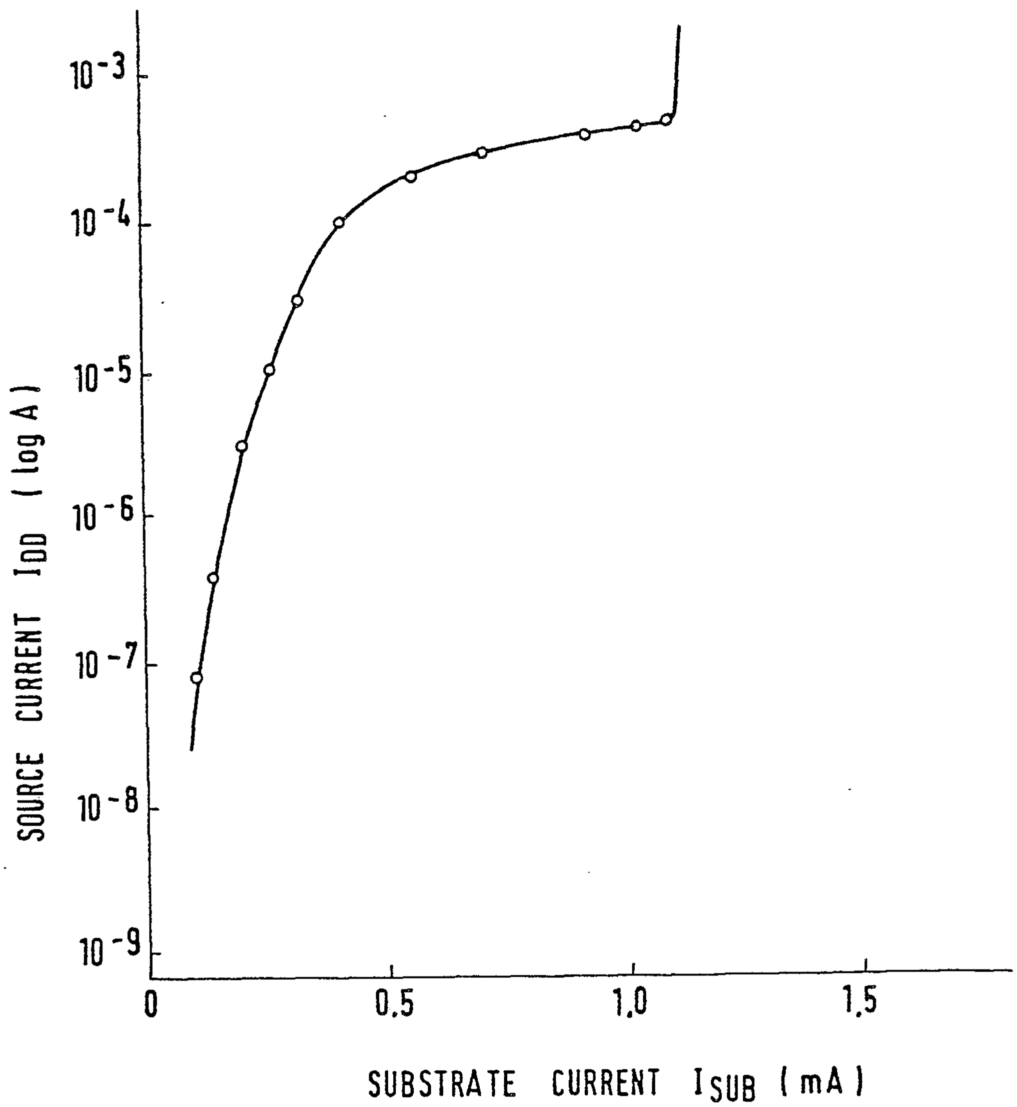
10 -3
10 -4
10 -5
10 -6
10 -7
10 -8
10 -9
SOURCE CURRENT IDD (log A)
0
0,5
1,0
1,5
SUBSTRATE CURRENT ISUB (mA)